# EUROPEAN PATENT APPLICATION

(11) **EP 1 691 399 A2**
(43) Date of publication of application: **16.08.2006**
(21) Application number: 06001557.5
(22) Date of filing: 25.01.2006
(51) Int. Cl.: H01L 21/02

(54) **Semiconductor device with capacitor structure for improving area utilization**

(30) Priority: 15.02.2005 JP 2005038172
(71) Applicant: Seiko NPC Corporation, Chuo-ku Tokyo 103-0026 (JP)
(72) Inventor: Sakamoto, Shuji, Chuo-ku Tokyo (JP)
(74) Representative: Grünecker, Kinkeldey, Stockmair & Schwanhäusser Anwaltssozietät

(57) **Abstract**

A semiconductor device with a capacitor structure for improving an area utilization, including a plurality of electrically conductive layers (2,4,6) and a plurality of dielectric layers (3,5), wherein each of the dielectric layers and each of electrically conductive layers are formed by alternately superposing, and the respective electrically conductive layers are alternately electrically connected.

## Description

### BACKGROUND OF THE INVENTION

### 1. FIELD OF THE INVENTION

The invention relates to a semiconductor device with a capacitor, in particular, to a structure of the capacitor.

### 2. DESCRIPTION OF THE RELATED ART

A capacitor in an existing semiconductor device generally has a structure where, above and below an insulating layer that constitutes a dielectric layer, electrically conductive layers constituting a pair of electrodes are formed. A capacitance value of the capacitor is determined by the dielectric constant of the dielectric layer and an area size of the capacitor. The area size means a facing area of the respective electrically conductive layers that sandwich the dielectric layer. (See Japanese Unexamined Patent Application Publication No.JP-A-5-190766)

### SUMMARY OF THE INVENTION

Accordingly, in the prior art capacitor structure, on condition that the dielectric constants are same, in order to increase the capacitance value, a facing area of the respective electrically conductive layers has to be increased. That is, in order to obtain a capacitor large in the capacitance value, a broader area size is necessary. Accordingly, in order to form a capacitor large in the capacitance value, a problem of a larger semiconductor device cannot be avoided. The invention intends to overcome the problem and thereby to provide a structure of a capacitor that, without increasing a semiconductor device in size, can obtain a large capacitance value.

In order to achieve an object, according to a first aspect of the invention, a capacitor structure includes a plurality of electrically conductive layers and a plurality of dielectric layers, wherein each of the dielectric layers and each of electrically conductive layers are formed by alternately superposing, and the respective electrically conductive layers are alternately electrically connected.

Similarly, in order to achieve the object, according to a second aspect of the invention, a semiconductor device with a capacitor structure, which includes a first capacitor electrode, a second capacitor electrode and a dielectric layer between them comprising, a first capacitor portion including a diffusion region formed in a semiconductor substrate, a first dielectric layer formed on the diffusion region and the second capacitor electrode formed on the first dielectric layer, and a second capacitor portion including the second capacitor electrode, a second dielectric layer formed on the second capacitor electrode and a conductive layer formed on the second dielectric layer, wherein the diffusion region and the conductive layer are electrically connected each other such that the diffusion region and the conductive layer comprise the first capacitor electrode.

Furthermore, in a capacitor structure involving a third aspect of the invention, in the semiconductor devices according to the second aspect of the invention, the diffusion region and said conductive layer are connected by a metal layer.

According to the inventions involving the first and second aspects of the application, a facing area of the electrically conductive layers that are a pair of electrodes that face each other with the dielectric layer interposed therebetween can be increased not planarly but superposedly. Accordingly, without enlarging the semiconductor device, a capacitor having a large capacitance value can be obtained.

According to the invention involving the third aspect of the application, in addition to the above advantages, electrical connections between the electrically conductive layers can be more assuredly carried out.

### BRIEF DESCRIPTION OF THE DRAWINGS

Fig. 1 is a schematic sectional view of a semiconductor device with a capacitor that is an embodiment of the invention.
Fig. 2 is a schematic plan view of a semiconductor device with a capacitor that is an embodiment of the invention.
Fig. 3 is a circuit diagram for explaining a constitution of a capacitor that is an embodiment of the invention.
Fig. 4 is a circuit diagram for explaining a constitution of a capacitor in another embodiment of the invention.

### DESCRIPTION OF THE PREFERRED EMBODIMENTS

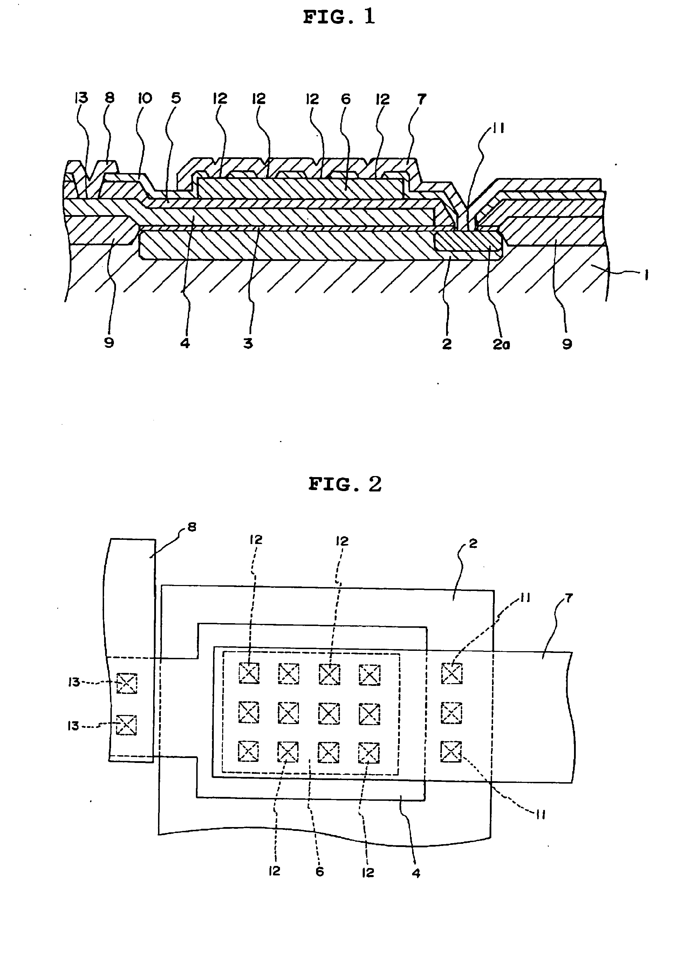

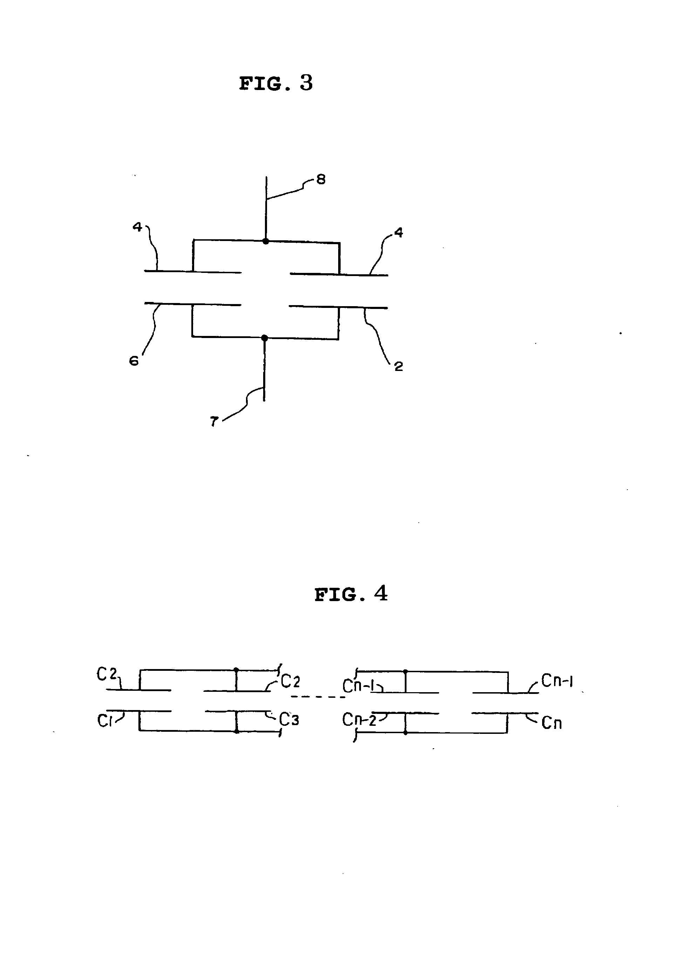

Now, preferred embodiments of the invention will be described with reference to Figs. 1 through 3. Here, Fig. 1 is a schematic sectional view of a semiconductor device with a capacitor, Fig. 2 being a plan view thereof, Fig. 3 being a circuit diagram explaining a constitution of a capacitor.

As shown in Fig. 1, on a silicon substrate 1 of the semiconductor device, an impurity ion such as arsenic or phosphorus is implanted to form an N-diffusion layer 2 and a region 2a where the impurity is partially implanted at a high concentration. On the diffusion layer 2 that is the electrically conductive layer, a first insulating layer 3 is formed with silicon oxide. On the first insulating layer 3, a lower electrically conductive layer 4 is formed with polysilicon. Thereby, with the first insulating layer 3 as a dielectric layer and with the diffusion layer 2 and the lower electrically conductive layer 4 as a pair of electrodes, a capacitor is formed.

Furthermore, on the lower electrically conductive layer 4, a second insulating layer 5 is formed with silicon oxide. On the second insulating layer 5, an upper electrically conductive layer 6 is formed with polysilicon. Thereby, with the second insulating layer 5 as a dielectric layer and with the lower electrically conductive layer 4 and the upper electrically conductive layer 6 as a pair of electrodes, a capacitor is formed. The lower electrically conductive layer 4 is an electrode common for both capacitors.

Still furthermore, while, on the upper electrically conductive layer 6 and the second insulating layer 5, an insulating layer 10 is formed with silicon oxide, the upper electrically conductive layer 6 and the high concentration region 2a of the diffusion layer 2 are electrically connected with a wiring 7 of metal such as aluminum. Thereby, as shown in Fig. 3, two capacitors are constituted to be connected in parallel. In Figs. 1 and 2, a reference numeral 11 denotes a contact region between the metal wiring 7 and the high concentration region 2a and a reference numeral 12 denotes a contact region between the metal wiring 7 and the upper electrically conductive layer 6.

Furthermore, as understood from Figs. 1 and 2, the lower electrically conductive layer 4 is electrically connected with an electrode of a MOS transistor formed on the silicon substrate 1, by a wiring 8 of metal such as aluminum, in a contact region 13. In Fig. 1, a reference numeral 9 denotes an LOCOS element isolation region.

In the embodiment, as mentioned above, a first capacitor with the diffusion layer 2 and the lower electrically conductive layer 4 as a pair of electrodes and a second capacitor with the lower electrically conductive layer 4 and the upper electrically conductive layer 6 as a pair of electrodes are superposedly formed, and the diffusion layer 2 and the upper electrically conductive layer 6 are electrically connected. Thereby, without horizontally expanding facing electrically conductive layers 2, 4 and 4, 6 that are pairs of electrodes, a facing area of electrodes can be increased. That is, when compared with one that has a same occupying area in a horizontal direction of the electrode, a capacitor having substantially two times the capacitance value can be obtained.

The invention is not restricted to the above embodiment. For instance, the diffusion layer 2 and the electrically conductive layer 6 can be electrically connected not through the metal wiring 7 but directly. When these are electrically connected not through the metal wiring 7 but directly, the high concentration region 2a of the diffusion layer 2 can be dispensed. Furthermore, superposing capacitors are not restricted to two and may be three or more. In this case, as shown in Fig. 4, electrically conductive layers, C1 through Cn, which are located above and below are only necessary to be alternately electrically connected.

## Claims

1. A semiconductor device with a capacitor structure for improving an area utilization, including a plurality of electrically conductive layers and a plurality of dielectric layers, wherein each of said dielectric layers and each of electrically conductive layers are formed by alternately superposing, and said respective electrically conductive layers are alternately electrically connected.

2. A semiconductor device with a capacitor structure, which includes a first capacitor electrode, a second capacitor electrode and a dielectric layer between them comprising:
a first capacitor portion including a diffusion region formed in a semiconductor substrate, a first dielectric layer formed on said diffusion region and said second capacitor electrode formed on said first dielectric layer; and
a second capacitor portion including said second capacitor electrode, a second dielectric layer formed on said second capacitor electrode and a conductive layer formed on said second dielectric layer,
wherein said diffusion region and said conductive layer are electrically connected each other such that said diffusion region and said conductive layer comprise said first capacitor electrode.

3. A semiconductor device according to claim 2, wherein said the diffusion region and said conductive layer are connected by a metal layer.
